# EUROPEAN PATENT APPLICATION

(11) **EP 1 085 516 A2**
(43) Date of publication of application: **21.03.2001**
(21) Application number: 00308053.8
(22) Date of filing: 15.09.2000
(51) Int. Cl.: G11C 7/16

(54) **Semiconductor storing apparatus and operation setting method of the same**

(30) Priority: 20.09.1999 JP 26544899
(71) Applicant: SONY CORPORATION, Tokyo (JP)
(72) Inventor: Imura, Shigeru, c/o Sony Corporation, Tokyo (JP)
(74) Representative: Nicholls, Michael John

(57) **Abstract**

A mode setting unit for setting a mode to insert an IC card called SIM into a memory card called a memory stick and input or output data to/from the memory card or a mode to insert the IC card into the memory card and input or output data to/from the IC card is provided. When the SIM is inserted into the memory stick, encryption information, charging information, personal information of the user, and the like can be recorded into the SIM and data of contents can be stored in the memory stick. The copyright of the contents data can be protected and legal charging can be performed. When data is recorded into the memory card, security can be raised and a compatibility with the existing memory card can be realized.

## Description

The invention particularly, but not exclusively, relates to a semiconductor storing apparatus suitable for use in the case of storing data, the contents of which are distributed through a network, and to an operation setting method of such a semiconductor storing apparatus.

A service of distributing music data by using the Internet has been started. According to such a service, a site for distributing music data is provided on the Internet. When the user accesses to the site and selects a desired music piece, the selected music data is transmitted via the Internet and downloaded into a recording medium.

A service of distributing music data by using a digital satellite broadcasting has been proposed. According to such a service, together with video data and audio data for providing a program, music data to be downloaded and data of a script language such as MHEG (Multimedia and Hypermedia Information Coding Experts Group), XML (eXtensible Markup Language), or the like to form a screen for downloading are sent as additional data by a music channel. The screen for downloading is formed by the data of the script language. When the user gives an instruction on the screen, the music data transmitted as data to be downloaded is downloaded to the recording medium.

Further, a service of distributing music data by using a cellular phone has been proposed. According to such a service, when the user connects his telephone line to a predetermined dial number by the cellular phone, he can receive the distribution of music data. When the user operates the cellular phone, desired music data is transmitted via a line network of the cellular phone and downloaded into the recording medium set in the cellular phone.

As mentioned above, services of providing contents such as music data, published matter, software of games, or the like by using various transmitting media such as Internet, digital satellite broadcasting, cellular phone line, and the like are considered. According to such services, the transmitted data is downloaded into the recording medium.

As a recording medium into which the data of contents is downloaded as mentioned above, a magnetic disk such as floppy disk, hard disk, or the like, an optical disk such as a CD-R (CD-Recordable) disk, or a magnetooptic disk such as an MO (Magneto-Optical) disk can be used. However, such a disk-shaped recording medium has a problem with being vibration proof because it includes a mechanical portion and it is difficult to carry it outside or easily use it because it is large in size.

The use of a memory card called a memory stick as a recording medium for downloading the data of contents as mentioned above has been proposed.

The memory stick is a card-shaped non-volatile semiconductor memory using a flash memory of an NAND type. The memory stick can be accessed at a high speed and a memory capacity of up to about 64 MB has been scheduled. The capacity of 64 MB of the memory stick is larger than that (1.4 MB) of the existing floppy disk and is considered to be a capacity enough to record the data of contents. Although this capacity is smaller than that (128 MB to 640 MB) of an MD (Mini Disc) or a CD-R, the MD or CD-R is large in size because it includes a mechanical portion and cannot be easily handled. On the other hand, the memory stick is small, can be easily handled, and has excellent vibration proof properties.

For example, in case of downloading the music data, there is a situation such that the user reproduces the downloaded music data by using portable stereophonic headphones or reproduces it by a car-mounted audio player. According to such a using method, the small memory stick with excellent vibration proof is considered to be a very useful recording medium.

However, in the present situation, a CPU (Central Processing Unit) is not built in the memory stick and a security function is inadequate. In case of downloading the music data, it is necessary to raise security for the purpose of protection of a copyright. Particularly, a method of charging by using electronic money when the data of those contents is obtained by using the network is being taken into consideration. According to the memory stick, since the CPU is not built in it, it is difficult to perform such a charging process.

An IC card has been known as a card in which a CPU is built. For example, in a cellular phone of a GSM (Global System for Mobile communications) system in Europe, an IC card called SIM conformed with ISO (International Organization for Standardization) 7816 is used. Such an IC card is used for storing an authentication, contract contents, an encrypting algorithm, abbreviation dial numbers, and the like in the cellular phone of the GSM system. The IC card having a built-in CPU is used in electronic money of a pay television or a mondex system. Such an IC card has a high secrecy against a copy and forgery as compared with the memory card.

However, in case of the IC card, since a memory capacity is small and an access speed is low, it is difficult to use it in application for storing the downloaded contents.

It is, therefore, an object of the invention to provide a semiconductor storing apparatus which can raise security and realize compatibility with an existing memory card and an operation setting method of such a semiconductor storing apparatus.

According to an aspect of the invention, there is provided a semiconductor storing apparatus with a construction of a memory card having a non-volatile semiconductor memory, data input/output control means for controlling input/output of data to/from the non-volatile semiconductor memory, and interface means with external equipment, wherein the apparatus comprises: IC card inserting means for inserting an IC card having control means, memory means, and data input/output control means for controlling input/output of data to/from the control means; and mode setting means for setting a mode for inputting/outputting data to/from the memory card or a mode for inserting the IC card into the memory card and inputting/outputting the data to/from the IC card.

According to another aspect of the invention, there is provided an operation setting method for a semiconductor storing apparatus with a construction of a memory card having a non-volatile semiconductor memory, data input/output control means for controlling input/output of data to/from the non-volatile semiconductor memory, and interface means with external equipment, wherein the method comprises the steps of: enabling an IC card having control means, memory means, and data input/output control means for controlling input/output of data to/from the control means to be inserted; and making it possible to set a mode for inputting/outputting data to/from the memory card or a mode for inserting the IC card into the memory card and inputting/outputting the data to/from the IC card.

An IC card called SIM can be inserted or removed into/from a memory card called a memory stick. Although the memory stick has an enough recording capacity and a sufficiently high transfer speed, since it does not have a CPU, there is a problem on security. The SIM has a CPU and has an adequate security function. Therefore, if the IC card called SIM is inserted into the memory card called a memory stick, encryption information, charging information, personal information of the user, and the like can be recorded in the IC card. A copyright of data of contents can be protected. Legal charging can be performed. Thus, for example, in case of using the services of providing the contents such as music data or the like by using various transmitting media such as Internet, digital satellite broadcasting, cellular phone line, and the like, an enough memory capacity can be assured, the copyright can be protected, and the legal charging can be performed.

Embodiments of the invention will now be described, by way of example only, with reference to the accompanying drawings in which:-
Fig. 1 is a perspective view for use in explanation of an example of a memory stick to which the invention is applied and to/from which an SIM can be inserted or removed;
Fig. 2 is a front view, a plan view, and a side elevational view for use in explanation of an example of the memory stick to which the invention is applied and to/from which the SIM can be inserted or removed;
Fig. 3 is a cross sectional view for use in explanation of an example of the memory stick to which the invention is applied and to/from which the SIM can be inserted or removed;
Fig. 4 is a block diagram for use in explanation of the SIM;
Fig. 5 is a block diagram for use in explanation of the memory stick;
Fig. 6 is a block diagram of an example of the memory stick to which the invention is applied and to/from which the SIM can be inserted or removed;
Fig. 7 is a block diagram of an example of the memory stick to which the invention is applied and to/from which the SIM can be inserted or removed;
Fig. 8 is a schematic diagram for use in explanation of an example of the memory stick to which the invention is applied and to/from which the SIM can be inserted or removed;
Fig. 9 is a flowchart for use in explanation of an example of the memory stick to which the invention is applied and to/from which the SIM can be inserted or removed; and
Fig. 10 is a block diagram of another example of the memory stick to which the invention is applied and to/from which the SIM can be inserted or removed.

An embodiment of the invention will be described in the following order hereinbelow with reference to the drawings.
1. External whole construction of the memory stick into/from which the SIM can be inserted or removed
2. Internal construction of the SIM
3. Internal construction of the memory stick
4. Example of the memory stick into/from which the SIM can be inserted or removed
5. Processing procedure from the external apparatus
6. Another example of the memory stick into/from which the SIM can be inserted or removed

### 1. External whole construction of the memory stick into/from which the SIM can be inserted or removed

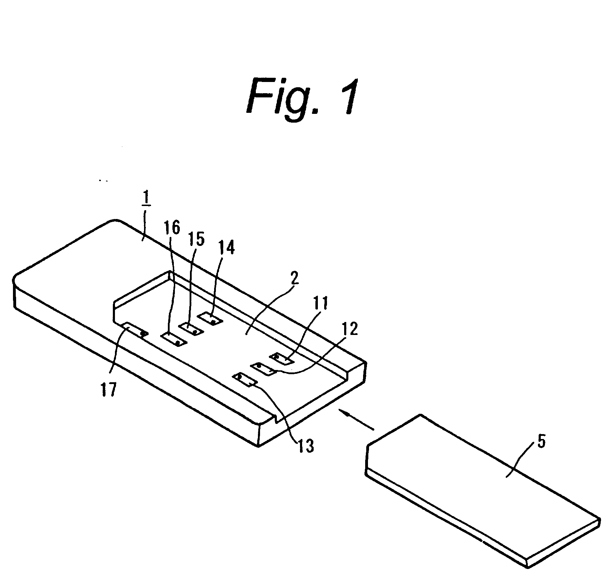

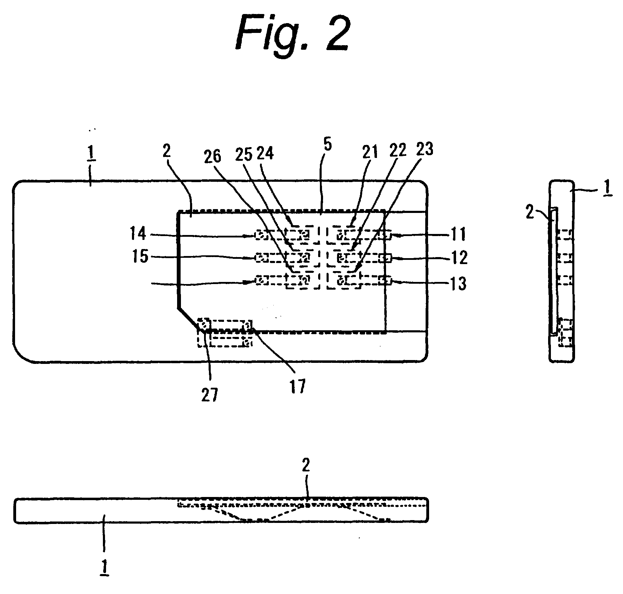

Figs. 1 and 2 show a whole construction of a memory card apparatus to which the invention is applied. In Figs. 1 and 2, reference numeral 1 denotes a memory card to which the invention is applied. The memory card 1 is constructed in a manner similar to a card-shaped memory called a memory stick. The memory stick is a card-shaped non-volatile semiconductor memory using a flash memory of the NAND type and a memory capacity of up to about 64 MB has been scheduled.

An SIM attaching portion 2 is formed on the upper surface of the memory card 1. The SIM attaching portion 2 is constructed by a concave portion corresponding to a shape of an IC card 5 which is called SIM and has therein a CPU. The IC card 5 can be inserted or removed into/from the SIM attaching portion 2 of the memory card 1.

Terminals for connecting the memory card 1 and IC card 5 are arranged on the SIM attaching portion 2. As those terminals, a power terminal 11, a reset output terminal 12, a clock output terminal 13, a grounding terminal 14, a programming power terminal 15, and a data input/output terminal 16 are provided. A detecting terminal 17 is provided on the memory card 1 in order to detect whether the IC card 5 has been inserted into the SIM attaching portion 2 or not.

The IC card 5 is inserted into the SIM attaching portion 2 of the memory card 1 in the inserting direction shown by an arrow. Thus, the whole IC card 5 is inserted into the SIM attaching portion 2 of the memory card 1 and the IC card 5 is fixed to the memory card 1.

When the IC card 5 is inserted to the memory card 1, as shown in Fig. 2, the power terminal 11, reset output terminal 12, clock output terminal 13, grounding terminal 14, programming power terminal 15, and data I/O terminal 16 arranged on the SIM attaching portion 2 of the memory card 1 are come into contact with a power terminal 21, a reset input terminal 22, a clock input terminal 23, a grounding terminal 24, a programming power terminal 25, and a data input/output terminal 26 arranged on the IC card 5, respectively.

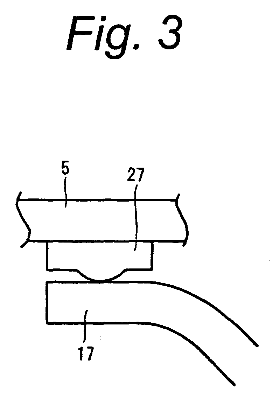

When the IC card 5 is inserted to the memory card 1, as shown in Fig. 3, the detecting terminal 17 arranged on the SIM attaching portion 2 of the memory card 1 is come into contact with a detecting terminal 27 arranged on the IC card 5, so that the fact that the IC card 5 has been inserted into the memory card 1 is detected.

As mentioned above, the memory card 1 is constructed in a manner similar to the card-shaped memory called a memory stick and a memory capacity of up to about 64 MB has been scheduled. The memory card 1 with such a construction of the memory stick is useful as a recording medium for recording contents data such as music data.

There is, however, a case where it is necessary to protect the copyright or charge with respect to the data of contents such as music data. The memory card 1 with such a construction of the memory stick has a problem of security and it is difficult to store protection information of the copyright and charging information, personal information of the user, and the like.

Therefore, in case of protecting the copyright or performing a legal charging, the IC card 5 is inserted into the memory card 1. For example, the copyright is protected by encrypting the contents data. The contents data is stored in the memory card 1. The encryption information, charging information, personal information of the user, and the like are recorded in the IC card 5.

As mentioned above, according to the invention, the memory card 1 with the construction of the memory stick and the IC card 5 with the construction of the SIM are detachable from each other. When the IC card 5 is removed from the memory card 1, the memory card can be used as an ordinary memory stick to record ordinary data. When the IC card 5 is inserted, the encryption information, charging information, personal information of the user, and the like can be recorded in the IC card 5. Thus, the copyright of the contents data can be protected and the legal charging can be performed.

Therefore, the memory card 1 with the construction of the memory stick from which the IC card 5 with the construction of the SIM is detachable is suitable when it is used as a recording medium to record the transmitted contents data in case of using the service of providing the contents such as music data or the like by using various transmitting media such as Internet, digital satellite broadcasting, cellular phone line, and the like. Particularly, since the SIM is used for storing the authentication based on the personal identification number of the subscriber, contract contents, encrypting algorithm, abbreviation dial numbers, and the like in the cellular phone of the GSM system, the SIM is useful in the service such as to transmit the contents data such as music data or the like by using the cellular phone.

### 2. Internal construction of the SIM

As mentioned above, according to the invention, the memory card 1 called a memory stick and the IC card 5 called SIM are detachable from each other. As mentioned above, the IC card called SIM is an IC card which conforms with ISO7816 and has therein the CPU and is used for storing the authentication based on the personal identification number of the subscriber, contract contents, encrypting algorithm, abbreviation dial numbers, and the like in the cellular phone of the GSM system.

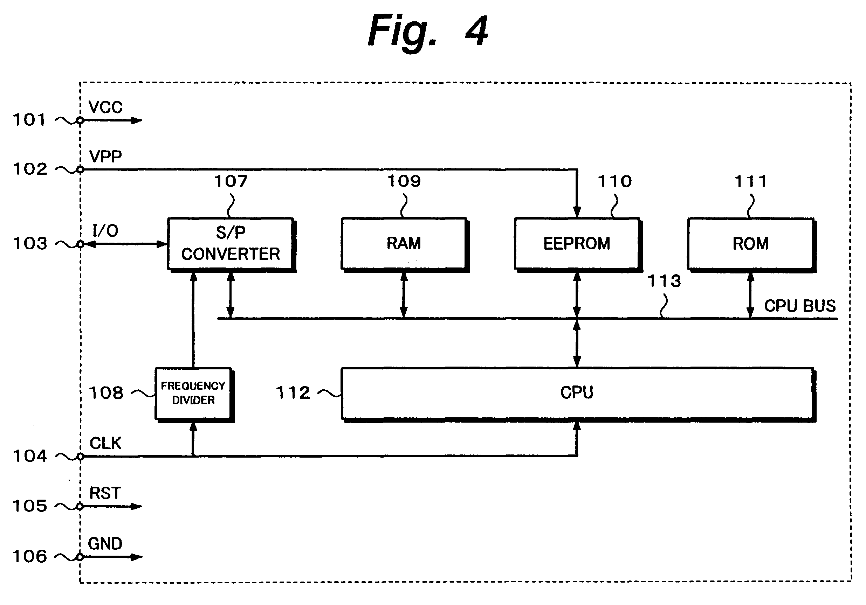

Fig. 4 is a block diagram showing an internal construction of an IC card called SIM. In Fig. 4, as connecting terminals with external equipment, a power terminal 101, a programming power terminal 102, an input/output terminal 103 of a bidirectional data signal line, a clock input terminal 104, a reset input terminal 105, a grounding terminal 106 are provided for the IC card, respectively.

The power terminal 101 is used for supplying an operating power source Vcc from the outside. A voltage of the operating power source Vcc is equal to 5V or 3V.

The programming power terminal 102 is used for supplying a power source Vpp for programming to a built-in EEPROM (Electrically Erasable and Programmable ROM) 110. The EEPROM 110 is an electrically erasable non-volatile memory. Generally, a voltage of the programming power source Vpp which is applied to the EEPROM 110 is equal to the power voltage Vcc. There is also an IC card such that the programming power source Vpp is generated in the SIM. Although a structure in which it is supplied from the outside is shown here, a supplying method is not essential here.

The data input/output terminal 103 is a data input/output terminal for actually inputting or outputting data via a bidirectional data signal line I/O. The data is inputted or outputted to/from the bidirectional data signal line I/O via a serial/parallel converter (S/P converter) 107. When no data is inputted or outputted, a voltage of the data signal line I/O is maintained to almost the same voltage as the operating power voltage Vcc. External control equipment and the SIM are in a mutually data receiving state.

A clock CLK is supplied to the clock input terminal 104. The clock CLK is an operating clock of a CPU (Central Processing Unit) 112 built in the SIM. The clock CLK is properly frequency divided by a frequency divider 108 and supplied to the S/P converter 107. The clock CLK which was frequency divided by the frequency divider 108 becomes a transfer clock for deciding a transfer speed of the data which is exchanged by the bidirectional data signal line I/O.

A reset signal RST is supplied to the reset input terminal 105. The reset signal RST is also used to initialize not only the built-in CPU 112 but also the frequency divider 108, S/P converter 107, and the like.

The grounding terminal 106 is connected to a ground Vss.

The input/output of the data is performed by the S/P converter 107 through the bidirectional data signal line I/O. The S/P converter 107 converts the data transferred as serial data from the external equipment into parallel data of, for example, 8 bits.

In the serial data which is inputted or outputted through the bidirectional data signal line I/O, a start bit at the "low (L)" level exists at the head, bit data of a positive logic of the LSB-first (or a negative logic of the MSB-first; either one of them is selected by a manufacturer of the IC card) subsequently continues, and one bit of a parity of an even number is added. The head of the data is detected by the start bit at the "L" level and the data is subsequently sent. An error is detected by the parity. In this instance, if the error is detected by the parity, the signal at the "L" level is transmitted from the reception side at a specific time between two clocks subsequent to the parity bit. Thus, the occurrence of the error is found on the transmission side. If the occurrence of the error is found, the transmission side transmits the same data again.

This method is a half-duplex asynchronous communication protocol of ISO7816. The S/P converter 107 performs the converting process between the serial data and the parallel data via those processes.

An RAM (Random Access Memory) 109 is a memory in/from which data can be written or read out anytime. The RAM 109 is used for temporarily storing data which is necessary at the time when the CPU 112 executes processes or temporarily storing several data.

Data which is used only inside, data which is continuously used while being updated on use, and the like are stored in the EEPROM 110. For example, at a digital cellular phone, abbreviation dial numbers, contract contents, short messages, control data for starting or maintaining the communication, or the like is stored in the EEPROM 110.

Although the EEPROM is used here, for example, a flash memory can be also used in place of the EEPROM.

Mainly, a program to be processed by the CPU 112 has been stored in an ROM (Read Only Memory) 111. A processing command comprises, for example: a published command system which is necessary to manufacture or use a cellular phone; and a non-public command system for management or identification number for operating data or the like which can be used only by a security, for example, scramble key generating unit, an issuer, or an administrator. By preparing the non-public command system for management as mentioned above, an SIM security function is further improved.

The frequency divider 108 is used to obtain the clock for sending the data by using a predetermined transfer rate of the bidirectional data signal line I/O from the clock CLK for making the CPU 112 operative. As a frequency dividing ratio of the frequency divider 108, for example, 1/372 is used in the cellular phone system of the GSM system. This frequency dividing ratio can be changed in accordance with a use object or use situation.

The CPU 112 executes processes in the SIM in accordance with commands from the outside. In this instance, whether the access right exists inside or not or the like is discriminated and processes are executed.

A data bus 113 is used for reading out commands from the ROM 111 or temporarily storing data when the CPU 112 executes the commands, for arbitrarily reading out or writing data from/into the RAM 109, or transferring data when the EEPROM 110 is accessed on the basis of a request from an external apparatus.

As mentioned above, according to the IC card with the construction of the SIM, the data such as abbreviation dial numbers, contract contents, short messages, control data for starting or maintaining the communication, or the like which is used only inside, the data which is continuously used while being updated on use, and the like are stored in the EEPROM 110. For example, a processing command comprising a published command system which is necessary to manufacture or use the cellular phone and a non-public command system for management for operating data or the like which can be used only by a security, for example, scramble key generating unit, an issuer, or an administrator is stored in the ROM 111. The data which is inputted or outputted is managed by the CPU 112. Therefore, a high security function is guaranteed.

### 3. Internal construction of the memory stick

The memory stick serving as a fundamental construction of the memory card 1 to which the invention is applied will be described.

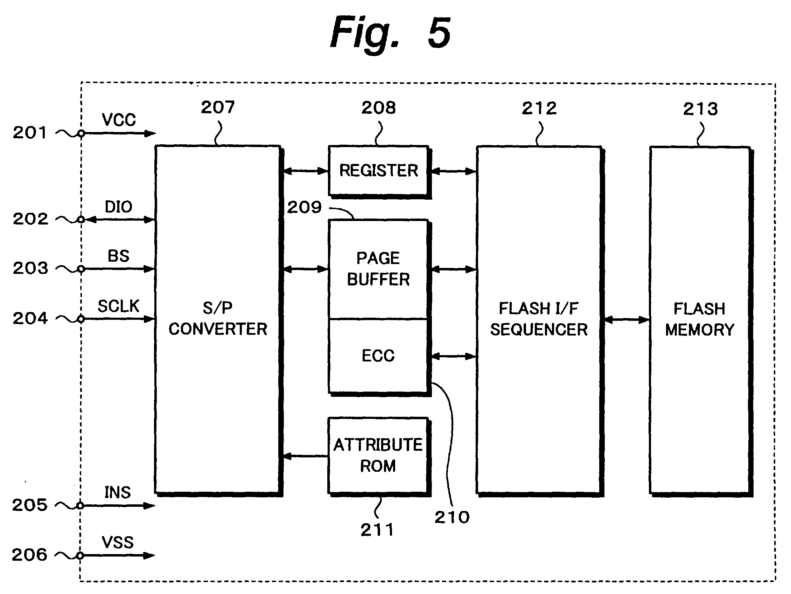

In Fig. 5, a power terminal 201, a data input/output terminal 202 for connecting to external equipment, an input terminal 203 of a bus state, an input terminal 204 of a transfer clock, a detecting terminal 205 for detecting an insertion or removal, and a grounding terminal 206 are arranged on the memory stick.

The power voltage Vcc is supplied to the power terminal 201. The operation can be performed if the voltage of the power voltage Vcc lies within a range from 2.7V to 3.6V.

The data is inputted or outputted from/to the data I/O terminal 202 via a bidirectional data signal line DIO. The data signal line DIO is used for writing or reading control data as a transfer protocol command (TPC) or the data itself.

A bus state BS is supplied to the input terminal 203 of the bus state. The bus state BS shows a status for the data on the bidirectional data signal line DIO. For example, the processes of the memory stick are executed by changing the state by the TPC before the data access is performed or by the data itself.

A transfer clock SCLK is supplied to the clock input terminal 204. The transfer clock SCLK is generated when the TPC or the data itself is transferred. The transfer clock SCLK is controlled by the bus state BS.

The detecting terminal 205 is used for the external apparatus to detect the inserting/removal state of the memory stick. In the memory stick, the detecting terminal 205 is connected to the ground and connected to a power source through a pull-up resistor by the external apparatus. Therefore, the detecting terminal 205 is set to the "L" level in the inserting state of the memory stick and to the "high (H)" level when it is not inserted.

The grounding terminal 206 is connected to the ground Vss.

In the writing mode, the S/P converter 207 converts the serial data transmitted synchronously with the transfer clock SCLK via the bidirectional data signal line DIO into the 8-bit parallel data. The control command and the data are also converted from the serial data to the parallel data.

In the reading mode, the 8-bit parallel data stored in the memory stick is converted into the serial data by a serial/parallel converter 207 and outputted to the external apparatus via the bidirectional data signal line DIO.

A register 208 comprises a status register, a parameter register, an extra data register, and the like and performs an access control of the memory in the memory stick by the TPC.

A page buffer 209 is used for temporarily storing data when a data exchange is performed between the S/P converter 207 and a flash memory 213.

An error detection code generating unit 210 adds, for example, an error detection code such as a CRC (Cyclic Redundancy Check) code or the like to the data to be outputted or the data which is inputted and detects an error of the data to be outputted or the data which is inputted. The reliability of the data is assured by performing such an error detection.

Physical information in the memory stick is stored in an attribute ROM 211. The information in the attribute ROM 211 is read out just after the power-on. The external apparatus uses the information in order to check a correspondence situation.

A flash I/F sequencer 212 controls the data between the page buffer 209 and flash memory 213 on the basis of a parameter or the like set in the register 208.

As a flash memory 213, a non-volatile memory card comprising, for example, an NAND type memory cell is used. The flash memory 213 is divided on a page unit basis of a certain memory capacity and the data is written/read out every page. Although there are various memory capacities of the flash memory 213, for example, a memory capacity of up to about 64 MB has been scheduled.

As mentioned above, in the memory stick, the data of, for example, up to about 64 MB can be recorded by the flash memory 213. In the memory stick, the access speed of about 20 Mb/sec can be assured by using a serial half-duplex synchronous data transfer system.

### 4. Example of the memory stick into/from which the SIM can be inserted or removed

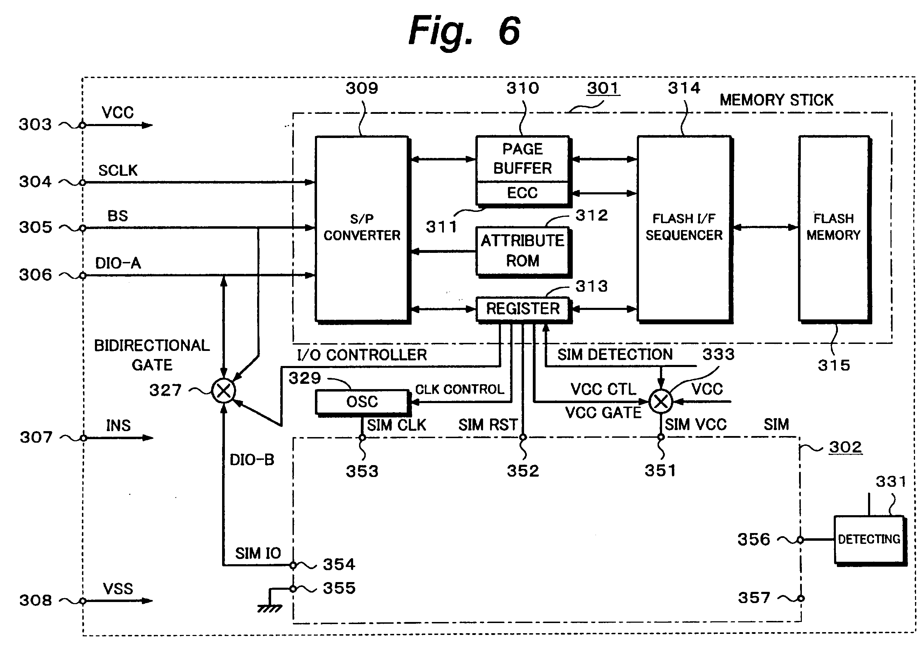

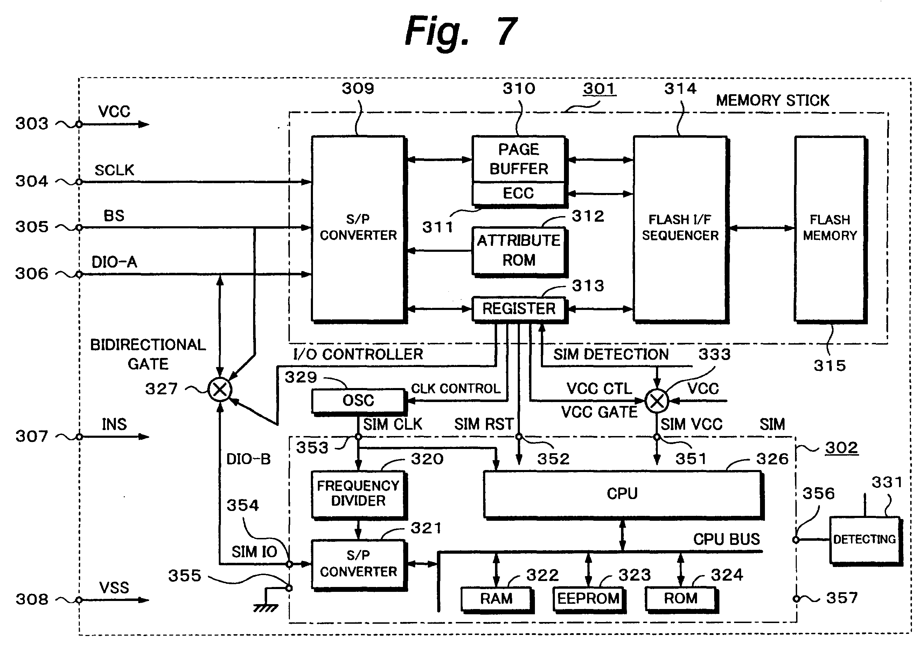

Figs. 6 and 7 are block diagrams showing an internal structure of the memory card 1 shown in Figs. 1 and 2. Fig. 6 shows a construction in a state where the IC card 5 with the construction of the SIM is removed. Fig. 7 shows a construction in a state where the IC card 5 with the construction of the SIM has been inserted.

In Figs. 6 and 7, a power terminal 303, a data input/output terminal 306, an input terminal 305 of the bus state, an input terminal 304 of a serial clock, a detecting terminal 307 for detecting an insertion or removal, and a grounding terminal 308 are arranged on the memory stick in which the IC card can be inserted.

The power voltage Vcc is supplied to the power terminal 303. The operation can be performed if the voltage of the power voltage Vcc lies within a range from 3V to 5V.

The data I/O terminal 306 is used for inputting or outputting the data via a bidirectional data signal line DIO-A.

The bus state BS is a signal which is controlled synchronously with the data transfer on the bidirectional data signal line DIO-A and shows a state of packet communication. An asynchronous mode such that the data is transmitted asynchronously without using the bus state BS is also possible. This system is a half-duplex asynchronous communication protocol of ISO7816 used in the SIM.

In the packet communicating state, the transfer clock SCLK is controlled by the bus state BS. The bus state BS is not used in the half-duplex asynchronous communication protocol.

The detecting terminal 307 for detecting an insertion or removal is used for the external apparatus to detect the inserting/removal state of the memory stick. This detecting terminal is used for the external apparatus to detect the inserting/removal state of the memory card. In the memory card, the detecting terminal 307 is connected to the ground Vss and connected to the power source through a pull-up resistor by the external apparatus. The detection signal INS is set to the "L" level in the inserting state of the memory card and to the "H" level when it is not inserted.

The grounding terminal 308 is connected to the ground Vss.

A serial/parallel converter 309, a page buffer 310, an error detection code generating unit 311, an attribute ROM 312, a flash I/F sequencer 314, and a flash memory 315 in Figs. 6 and 7 are similar to those of the memory stick as mentioned above. A register 313 includes an SIM interface register.

That is, in the writing mode, the S/P converter 309 converts the serial data transmitted synchronously with the transfer clock SCLK via the bidirectional data signal line DIO-A into the 8-bit parallel data. The control command and the data are also converted from the serial data to the parallel data. In the reading mode, the 8-bit parallel data stored in the memory is converted into the serial data by the S/P converter 309 and outputted to the external apparatus via the bidirectional data signal line DIO-A.

The register 313 comprises a status register, a parameter register, an extra data register, and the like and performs an access control of the memory in the memory stick by the TPC. Further, the register 313 includes an SIM interface register. The SIM interface register will be described in detail hereinlater.

The page buffer 310 is used for temporarily storing data when a data exchange is performed between the S/P converter 309 and flash memory 315.

The error detection code generating unit 311 adds, for example, an error detection code such as a CRC (Cyclic Redundancy Check) code or the like to the data to be outputted or the data which is inputted and detects an error of the data to be outputted or the data which is inputted. The reliability of the data is assured by performing such an error detection.

Physical information in the memory stick is stored in an attribute ROM 312. The information in the attribute ROM 312 is read out just after the power-on. The external apparatus uses the information in order to check a correspondence situation.

The flash I/F sequencer 314 controls the data between the page buffer 310 and flash memory 315 on the basis of a parameter or the like set in the register 313.

As a flash memory 315, a non-volatile memory card comprising, for example, an NAND type memory cell is used. The flash memory 315 is divided on a page unit basis of a certain memory capacity and the data is written/read out every page. Although there are various memory capacities of the flash memory 315, for example, a memory capacity of up to about 64 MB has been scheduled.

As mentioned above, a construction of a memory stick portion 301 is similar to the construction (Fig. 5) of the ordinary memory stick except that the SIM interface register is provided for the register portion 313.

A power terminal 351, a reset output terminal 352, a clock output terminal 353, a data input/output terminal 354, a grounding terminal 355, and a detecting terminal 356 for detecting an insertion/removal of the IC card are arranged on the memory card in order to connect it to the IC card with the SIM construction.

The operating power source Vcc is supplied to the IC card 5 via the power terminal 351 when the IC card 5 is inserted. When the IC card 5 is inserted, the power source of 5V or 3V is supplied to the power terminal 351.

The reset output terminal 352 is used for supplying the reset signal RST to the IC card 5 when the IC card 5 is inserted.

The clock output terminal 353 is used for supplying the clock CLK to the IC card 5 when the IC card 5 is inserted.

The data I/O terminal 354 is used to input or output the data to/from the IC card 5 when the IC card 5 is inserted.

The grounding terminal 355 is connected to the ground Vss.

A detecting unit 331 detects whether the IC card 5 with the SIM construction has been inserted into the memory card 1 or not.

Further, in the IC card with the SIM construction, when a flash memory is used in place of the EEPROM, the programming power source Vpp is necessary. For this purpose, a power terminal 357 for programming is prepared.

The power terminal 351, reset output terminal 352, clock output terminal 353, data I/O terminal 354, grounding terminal 355, detecting terminal 356, and programming power terminal 357 correspond to the power terminal 11, reset output terminal 12, clock output terminal 13, data I/O terminal 16, grounding terminal 14, detecting terminal 17, and programming power terminal 15 arranged in the SIM attaching portion 2 in Figs. 1 and 2, respectively.

Fig. 7 shows a state where the IC card 5 is inserted to the memory card 1. The portion of the IC card 5 is shown as an SIM portion 302. The SIM portion 302 has a construction similar to that (Fig. 4) of the foregoing SIM.

That is, the input/output of the data is performed via a serial/parallel converter 321. The S/P converter 321 converts the data transferred as serial data from external equipment into the parallel data of, for example, 8 bits.

According to the serial data which is inputted or outputted via a bidirectional data signal line SIM I/O, the start bit at the "L" level exists at the head and, bit data of a positive logic of the LSB-first or a negative logic of the MSB-first subsequently continues, and one bit of a parity of an even number is added. The head of the data is detected by the start bit at the "L" level and the data is subsequently sent. An error is detected by the parity. In this instance, if the error is detected by the parity, the signal at the "L" level is transmitted from the reception side at a specific time between two clocks subsequent to the parity bit. Thus, the occurrence of the error is found on the transmission side. If the occurrence of the error is found, the transmission side transmits the same data again. This method is a half-duplex asynchronous communication protocol of ISO7816. The S/P converter 107 performs the converting process between the serial data and the parallel data via those processes.

An RAM 322 is a memory in/from which data can be written or read out anytime. The RAM 322 is used for temporarily storing data which is necessary when a CPU 326 executes processes or temporarily storing several data.

Data which is used only inside, data which is continuously used while being updated on use, and the like are stored in an EEPROM 323. For example, at a digital cellular phone, abbreviation dial numbers, contract contents, short messages, control data for starting or maintaining the communication, or the like is stored in the EEPROM 323. A flash memory can be also used in place of the EEPROM.

Mainly, a program to be processed by the CPU 326 has been stored in an ROM 324. A processing command comprises, for example: a published command system which is necessary to manufacture or use a cellular phone; and a non-public command system for management or identification number for operating data or the like which can be used only by a security, for example, scramble key generating unit, an issuer, or an administrator.

A frequency divider 320 is used to obtain the clock for sending the data by using a transfer rate of a bidirectional data signal line DIO-B from a clock SIM CLK for making the CPU 326 operative.

The CPU 326 executes processes in the SIM in accordance with commands from the outside. In this instance, whether the access right exists inside or not or the like is discriminated and processes are executed.

A data bus 325 is used for reading out commands from the ROM 324 or temporarily storing data when the CPU 326 executes the commands, for arbitrarily reading out or writing data from/into the RAM 322, or transferring data when the EEPROM 323 is accessed on the basis of a request from an external apparatus.

In Figs. 6 and 7, the clock input terminal 304, input terminal 305 of the bus state, and data input/output terminal 306 are directly connected to the S/P converter 309 of the memory stick portion 301. Therefore, the serial clock SCLK from the clock input terminal 304 and the bus state BS from the input terminal 305 of the bus state are directly supplied to the S/P converter 309. The data can be directly inputted or outputted by the bidirectional data signal line DIO-A. As shown in Fig. 6, therefore, when the IC card 5 is removed, only the memory stick portion 301 is made to function and can be made operative as a memory stick.

As shown in Fig. 7, when the IC card 5 is inserted, the memory stick portion 301 can be made operative or the SIM portion 302 can be also made operative.

An SIM interface register is included in the register 313. The SIM interface register is used for controlling the operation in case of inputting or outputting data by using the memory stick portion 301 and the operation in case of inputting or outputting data by using the SIM portion 302. The contents in the SIM interface register 313 can be set by the data which is supplied from external equipment to the S/P converter 309. The contents in the SIM interface register can be set in response to a detection output of the detecting unit 331 for detecting whether the IC card 5 with the SIM construction has been inserted or not.

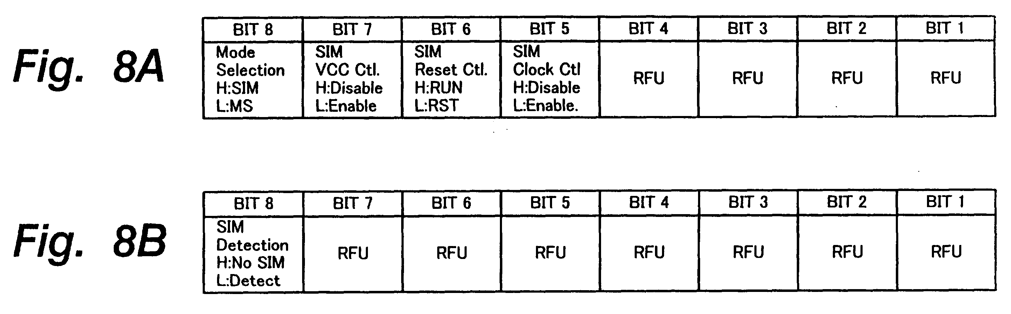

Figs. 8A and 8B show a construction of the SIM interface register. The SIM interface register is divided into a control register portion (Fig. 8A) and a status register portion (Fig. 8B) and constructed as a part of the register 313 shown in the example of the internal structure of the memory stick.

Fig. 8A shows a construction of the control register portion. The control register portion comprises bits Bit1 to Bit8. Bit1 to Bit4 are RFU bits and used for future expansion. The bits Bit1 to Bit4 are not used here.

The bit Bit8 in the control register portion is a mode selection bit and used for allowing the external apparatus to select whether the memory stick portion 301 is made operative or the SIM portion 302 is made operative when the IC card with the SIM construction is inserted into the memory card.

When the mode selection bit of the bit Bit8 in the control register portion is at the "H" level, the SIM mode is set and the SIM portion 302 is made operative. When the mode selection bit of the bit Bit8 in the control register portion is at the "L" level, the memory stick mode is set and the memory stick portion 301 is made operative.

The bit Bit7 in the control register portion is used for controlling a power voltage which is supplied to the SIM portion 302. When the power control bit Bit7 is at the "H" level, "disable" is set. When it is at the "L" level, "enable" is set.

The bit Bit6 is used for controlling a reset/run signal which is sent to the SIM portion 302. When the reset control bit Bit6 is at the "H" level, "RUN" is set. When it is at the "L" level, "RST" is set.

Further, the bit Bit5 is used for controlling the clock which is sent to the SIM portion 302. When the clock control bit Bit5 is at the "H" level, "disable" is set. When it is at the "L" level, "enable" is set.

Fig. 8B shows a construction of the status register portion. The status register portion comprises the bits Bit1 to Bit8. Bit1 to Bit7 are RFU bits and used for further expansion. The bits Bit1 to Bit7 are not used here.

The bit Bit8 in the status register portion is an SIM detection bit and shows whether the IC card with the SIM construction has been inserted in the memory card or not. When the SIM detection bit of Bit8 in the status register portion is at the "H" level, the IC card is not detected. When the SIM detection bit of Bit8 in the status register portion is at the "L" level, the IC card is detected. This bit is set in response to the detection output of the detecting unit 331.

In Fig. 7, a bidirectional gate 327 switches the data which is inputted or outputted to/from the external equipment via the data I/O terminal 306.

The bidirectional gate 327 is controlled so as to connect the bidirectional data signal lines DIO-A and DIO-B only in case of the conditions such that the mode selection bit (Bit8) in the control register portion of the SIM interface register in Fig. 7 is at the "H" level and the bus state BS is at the "L" level.

In this instance, therefore, the data can be inputted or outputted between the SIM portion 302 and the external equipment via the data input/output terminal 306, bidirectional data signal line DIO-A, bidirectional gate 327, and bidirectional data signal line DIO-B.

Although the S/P converter 321 of the SIM portion 302 is made to function under conditions similar to those mentioned above, the bidirectional gate 327 is controlled in such a manner that the S/P converter 309 of the operation memory stick portion 301 does not function.

On the contrary, when the same conditions as those mentioned above are not satisfied, the bidirectional gate 327 is controlled in such a manner that the bidirectional data signal lines DIO-A and DIO-B are disconnected. The bidirectional gate 327 is controlled in such a manner that the S/P converter 309 of the operation memory stick portion 301 functions.

When the IC card with the SIM construction is inserted to the memory card, the operating clock SIM CLK of the SIM portion 302 is supplied from an oscillator 329. This clock is controlled by the clock control bit (Bit5) in the control register portion (Fig. 8A) of the SIM interface register.

A reset signal SIM RST of the SIM portion 302 is controlled by the reset control bit (Bit6) in the control register portion (Fig. 8A) of the SIM interface register.

Further, a power source SIM Vcc which is supplied to the SIM portion 302 is supplied from a power terminal 303 via a Vcc gate 333. The Vcc gate 333 is controlled by the power control bit (Bit7) in the control register portion (Fig. 8A) of the SIM interface register.

The power voltage Vcc is supplied to the SIM portion 302 via the Vcc gate 333 only under conditions such that the SIM detection bit (Bit8 in the status register portion of the SIM interface register) showing that the IC card with the SIM construction has been inserted is at the "L" level and the power control bit (Bit7) in the control register portion (Fig. 8A) of the SIM interface register is at the "L" level.

When the bus state BS at the input terminal 305 is at the "H" level, the apparatus operates as a 2-state access mode of the memory stick and the SIM interface register can be accessed. In this instance, the bidirectional gate 327 is turned off and no data is transferred to the SIM portion 302.

### 5. Processing procedure from the external apparatus

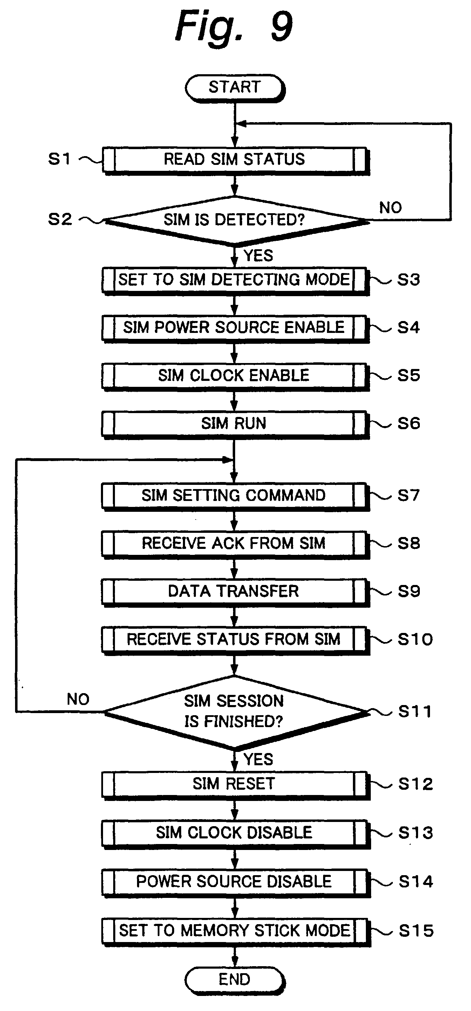

A procedure for controlling the memory card in which the IC card can be inserted from the external apparatus will now be described. Fig. 9 is a flowchart showing processes in the case where the memory card in which the IC card can be inserted is controlled from the external apparatus.

First, the SIM status is read out by the external apparatus in order to confirm whether the IC card has been inserted or not (step S1). That is, the SIM detection bit (Bit8) in the status register portion of the SIM interface register shown in Fig. 8B is read.

Whether the IC card 5 with the SIM construction has been inserted or not is discriminated from the SIM detection bit in the status register portion of the SIM interface register. If it is not detected, the processing routine is returned to step S1 and the SIM detection bit is read again (step S2).

If it is determined in step S2 that the IC card 5 with the SIM construction has been inserted, the apparatus is set into the SIM mode in order to control the operation of the SIM portion 302 (step S3). That is, in the control register portion of the SIM interface register shown in Fig. 8A, the mode selection bit of the bit Bit8 is set to the "H" level in a state where the bus state BS is at the "H" level.

After that, it is assumed that the accesses to the control register portion and status register portion of the SIM interface register are executed by similarly setting the bus state BS to the "H" level.

After that, the power control is set to "enable" in order to supply the power voltage Vcc to the SIM portion 302 (step S4). That is, in the control register portion of the SIM interface register, the power control bit of the bit Bit7 is set to the "L" level.

When the operating power source to the SIM portion 302 is settled, the clock control is set to "enable" in order to supply the operating clock SIM CLK to the SIM portion 302 (step S5). That is, in the control register portion of the SIM interface register, the clock control bit of the bit Bit5 is set to the "L" level. Thus, the oscillator 329 is controlled and the clock from the oscillator 329 is supplied to the SIM portion 302.

When the SIM operating clock is settled, a control is performed so as to set the SIM to "RUN" in order to activate the SIM (step S6). That is, in the control register portion of the SIM interface register, the reset control bit of the bit Bit6 is set to the "L" level. Thus, the reset signal changes to "RUN" and the SIM portion 302 is activated.

Although not described in the flowchart, a series of data called "Answer-To-Reset" specified in ISO7816-3 is outputted from the SIM portion 302 to the external apparatus. It shows a communication protocol type between the external apparatus and the SIM, is information data to decide whether the logic is the positive logic of the LSB-first or the negative logic of the MSB-first, and becomes interface regulations with the external apparatus at the time when the SIM portion 302 exchanges the data.

After the setting of the communication protocol type, the apparatus enters an ordinary data exchange session.

The external apparatus first issues the command to the SIM and transfers five bytes comprising an application code, a command code, and three parameter codes to the SIM portion 302 (step S7).

When such a command set is received, the SIM portion 302 returns a notification indicative of the fact that the command set has been received as an ACK signal to the external apparatus. The external apparatus performs a process for receiving the ACK from the SIM portion 302 (step S8).

A process for transferring the data from the external apparatus to the SIM or from the SIM to the external apparatus is performed in accordance with the command contents set by the command set in the SIM portion 302 in step S7 (step S9). At a point when the data transfer is finished, the SIM portion 302 returns a status word as processing result information to the external apparatus. The external apparatus, therefore, executes the process for receiving the status from the SIM portion (step S10).

The session of one time is finished as mentioned above. When the session of one time is finished, an SIM session end process is performed and further whether there is a session or not is discriminated (step S11). In case of continuing the session, the processing routine is returned to step S7 and a process for setting the command into the SIM is executed.

If it is determined in step S11 that the session is finished, a process for stopping the SIM and setting it into a reset state is executed in order to perform a shut-down procedure (step S12). That is, in the control register portion of the SIM interface register, the reset control bit of the bit Bit6 is set to the "L" level. Thus, the reset signal changes to "RST" and the SIM portion 302 is reset.

Subsequently, a process for disabling the clock is performed to stop the operating clock (step S13). That is, in the control register portion of the SIM interface register, the clock control bit of the bit Bit5 is set to the "H" level. Thus, the clock control signal changes and the clock from the oscillator 329 is stopped.

When the operating clock is stopped, a process for disabling the power source is performed to subsequently stop the operating power source Vcc (step S14). That is, the power control bit Bit7 in the control register portion of the SIM interface register is set to the "H" level. Thus, the control signal to the Vcc gate 333 changes and the supply of the power source SIM Vcc to the SIM portion 302 is stopped.

Finally, a process for setting the mode into the memory stick is performed to return the operating mode to the ordinary memory stick mode (step S15). That is, in the control register portion of the SIM interface register, the mode selection bit of the bit Bit8 is set to the "L" level.

As for the SIM mode described here by using the flowchart, if one session has been completed, by changing the mode selection bit of the bit Bit8, the mode can be changed temporarily or interruptively without executing the end procedure of the SIM. In this instance, the SIM portion 302 is in an idle mode. Further, in the case where the clock stop is permitted for the inserted SIM portion 302, it is also possible to stop the clock and set the SIM portion 302 into a sleep mode. In this instance, in the control register portion of the SIM interface register, the clock control bit of the bit Bit5 is set to the "H" level.

### 6. Another example of the memory stick into/from which the SIM can be inserted or removed

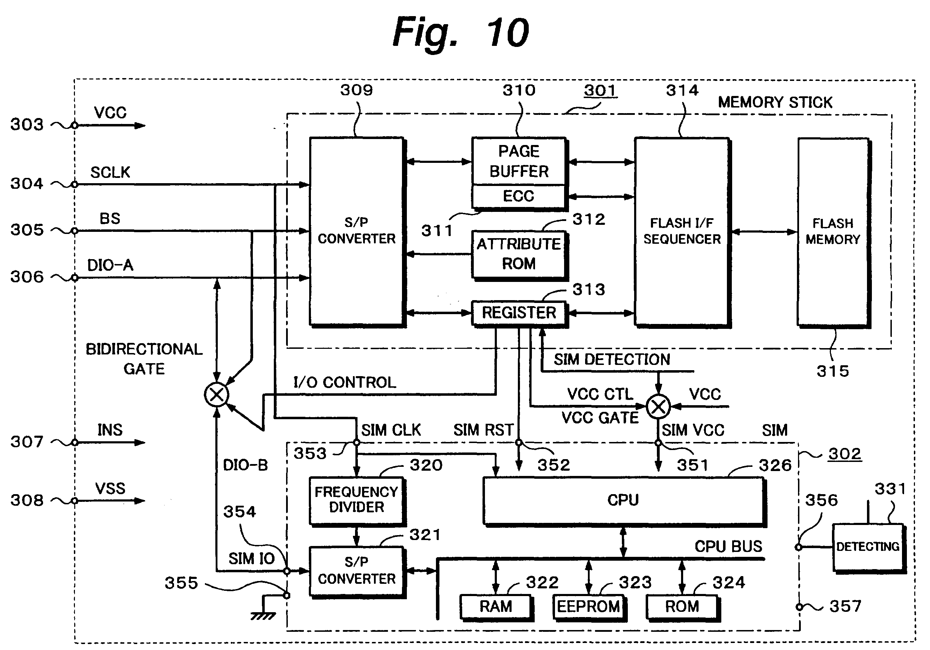

Fig. 10 shows another embodiment of the invention. In the foregoing examples shown in Figs. 6 and 7, the oscillator 329 has been provided to form the operating clock SIM CLK for the SIM portion 302. In another example, however, a clock from a clock input terminal SCLK is used as a clock to the SIM portion 302. The other construction is similar to that in the examples shown in Figs. 6 and 7 mentioned above.

As for the operating clock SCLK of the memory stick portion 301, when the memory stick portion is accessed, the supply state and the stop state frequently appear. In case of using such a construction, therefore, a condition such that the SIM portion 302 has the sleep mode in which the clock has been stopped is necessary.

Since a control procedure from the external apparatus is similar to that in the example shown in Fig. 9, its explanation is omitted here.

When the SIM clock is controlled, the clock control bit Bit5 in the SIM interface control register is invalid and there is no need to operate it. However, the operation similar to that mentioned above is executed by controlling the operating clock SCLK by the external apparatus in place of it.

Although the SIM can be inserted or removed into/from the memory stick in the above example, there is not always necessary to construct the apparatus in such a manner that the SIM can be physically inserted or removed into/from the memory stick. The SIM can be also integratedly attached to the memory stick.

According to the invention, the IC card called SIM can be inserted or removed into/from the memory card called a memory stick. The SIM is used as an IC card and the existing SIM can be inserted or removed as it is. Since the interface can be used in common, the memory card can be used as a memory stick irrespective of the presence or absence of the SIM. The interface with the external apparatus can use a signal line in common for the memory stick and the SIM and there is no need to newly provide an interface. It is almost unnecessary to increase the number of registers for controlling the memory stick portion and the SIM portion and switch the oscillator and the data signal.

Although the memory stick has an enough recording capacity and a sufficiently high transfer speed, there is a problem of the security because it does not have a CPU. The SIM has a CPU and has a sufficiently high security function. By enabling the SIM to be inserted into the memory stick, mutual advantages can be used. For example, the data which is stored in the memory stick portion can be encrypted by using the encryption key generated by the SIM portion. For example, it is also possible to construct the apparatus in such a manner that the memory stick portion can be accessed only when the SIM is inserted.

Therefore, if the IC card called SIM is inserted to the memory card called a memory stick, the encryption information, charging information, personal identification information of the user, and the like can be recorded in the IC card. The copyright of the contents data can be protected and the legal charging can be performed.

Thus, for example, in case of using the services of providing the contents such as music data or the like by using various transmission media such as Internet, digital satellite broadcasting, cellular phone line, and the like, an enough memory capacity can be assured, the copyright of the contents data can be protected, and the legal charging can be performed.

The present invention is not limited to the foregoing embodiments but many modifications and variations are possible within the scope of the invention as defined in the appended claims.

## Claims

1. A semiconductor storing apparatus with a construction of a memory card having a non-volatile semiconductor memory, data input/output control means for controlling an input or output of data to/from said non-volatile semiconductor memory, and interface means with external equipment, comprising:
IC card insertion means for receiving an insertable IC card having control means, memory means, and data input/output control means for controlling an input or output of data to/from said control means; and
mode setting means for setting a mode to input or output data to/from said memory card or a mode to input or output data to/from said IC card inserted to said memory card.

2. An apparatus according to claim 1, further comprising selecting means for switching the input/output of the data between said external equipment and said memory card and the input/output of the data between said external equipment and said IC card in accordance with said mode setting means.

3. An apparatus according to claim 1 or 2, further comprising power control means for controlling a supply of a power source to said IC card in accordance with said mode setting means.

4. An apparatus according to claim 1, 2 or 3, further comprising reset/run control means for controlling a resetting/running operation of said IC card in accordance with said mode setting means.

5. An apparatus according to any one of the preceding claims, further comprising oscillating means for generating a clock for said IC card,
and wherein a clock operation of said IC card is controlled by controlling said oscillating means in accordance with said mode setting means.

6. An apparatus according to any one of the preceding claims, wherein a clock from said external equipment is frequency divided and supplied to said IC card.

7. An apparatus according to any one of the preceding claims, wherein said IC card is detachably insertable into said IC card insertion means and said apparatus further has detecting means for detecting whether said IC card has been inserted or not.

8. An apparatus according to any one of the preceding claims, wherein said mode setting means is provided in a register of said memory card.

9. An operation setting method for a semiconductor storing apparatus with a construction of a memory card having a non-volatile semiconductor memory, data input/output control means for controlling an input or output of data to/from said non-volatile semiconductor memory, and interface means with external equipment, comprising the steps of:
enabling an IC card having control means, memory means, and data input/output control means for controlling an input or output of data to/from said control means to be inserted; and
enabling a mode to input or output data to/from said memory card or a mode to insert said IC card into said memory card and input or output data to/from said IC card to be set.

10. A method according to claim 9, wherein the input/output of the data between said external equipment and said memory card and the input/output of the data between said external equipment and said IC card are switched in accordance with said set mode.

11. A method according to claim 9 or 10, wherein a supply of a power source to said IC card is controlled in accordance with said set mode.

12. A method according to claim 9, 10 or 11, wherein a resetting/running operation of said IC card is controlled in accordance with said set mode.

13. A method according to any one of claims 9 to 12, wherein oscillating means is controlled in accordance with said set mode and a clock operation of said IC card is controlled.

14. A method according to any one of claims 9 to 13, wherein a clock from said external equipment is frequency divided and supplied to said IC card.

15. A method according to any one of claims 9 to 14, comprising detecting whether said IC card has been inserted or not.

16. A method according to any one of claims 9 to 15, wherein said mode setting is performed in a register of said memory card.
